# EUROPÄISCHE PATENTSCHRIFT

(11) **EP 2 745 274 B1**
(45) Veröffentlichungstag und Bekanntmachung des Hinweises auf die Patenterteilung: **05.07.2017**
(21) Anmeldenummer: 11782377.3
(22) Anmeldetag: 17.08.2011
(51) Int. Cl.: B60R 19/48, G07C 9/00, E05B 53/00, E05B 83/18, E05B 85/00, H01B 11/18, H03K 17/96, E05F 15/73, E05F 15/76

(54) **VORRICHTUNG ZUR BETÄTIGUNG EINER TÜR ODER KLAPPE AN EINEM FAHRZEUG**
APPARATUS FOR OPERATING A DOOR OR HATCH ON A VEHICLE
DISPOSITIF D'ACTIONNEMENT D'UNE PORTE OU D'UNE TRAPPE SUR UN VÉHICULE

(43) Veröffentlichungstag der Anmeldung: 25.06.2014
(73) Patentinhaber: Huf Hülsbeck & Fürst GmbH & Co. KG, 42551 Velbert (DE)
(72) Erfinder: VAN GASTEL, Peter, 42699 Solingen (DE); LINDIC, Iko, 45149 Essen (DE)
(86) Internationale Anmeldenummer: PCT/DE2011/075195
(87) Internationale Veröffentlichungsnummer: WO 2013/023629

(56) Entgegenhaltungen:
- EP-A1- 1 600 336
- WO-A1-2011/080324
- DE-A1-102008 063 366
- US-A- 4 766 368
- US-A1- 2005 236 846

## Beschreibung

Die Erfindung betrifft eine Vorrichtung zur Betätigung einer Tür oder Klappe eines Fahrzeugs, wobei die Vorrichtung eine Sensoreinheit aufweist, um eine Detektion eines Objektes in wenigstens einem an das Kraftfahrzeug angrenzenden Detektionsbereich zu ermöglichen, so dass über die Detektion die Betätigung des beweglichen Teils aktivierbar ist. Eine solche Vorrichtung ist beispielsweise aus der US2005/236846 bekannt. Aus dem Stand der Technik ist eine Sensoreinheit bekannt, welche an einem Stoßfänger angeordnet ist. Bei der Sensoreinheit handelt es sich um eine Eindrahtelektrode, welche als Seele einen Kupferdraht aufweist, die von einer Kunststoffschicht ummantelt ist. Nachteilig bei solch einer Sensoreinheit ist allerdings die geringe Reichweite zur Erfassung des Benutzers, welcher sich der Heckklappe nähert. Der Sensor detektiert den Benutzer erst knapp vor dem Stoßfänger, so dass bei einem schlüsselfreien Schließsystem sich die Heckklappe erst sehr spät öffnet. Ein solches System ist in der DE102008063366 offenbart. Aus der WO2011080324A1 ist ein Koaxialkabel bekannt, welches als Sensoreinheit in einem Kraftfahrzeugsitz dient. Die innere Seele des Koaxialkabels ist dabei als Referenzleiterelement ausgebildet, welches als Sensor dient.

Aufgabe der Erfindung ist es daher eine Vorrichtung zur Betätigung einer Tür oder Klappe eines Fahrzeugs mit einer Sensoreinheit bereitzustellen, die eine größere Reichweite zur Detektion des Benutzers aufweist. Diese Aufgabe wird durch eine Vorrichtung nach Anspruch 1 gelöst, bei der die Sensorheit als Koaxialkabel ausgebildet ist, dessen erste metallische Ummantelung die Sensorelektrode bildet, wobei ein als metallische Seele ausgebildeter Leiter des Koaxialkabels das gleiche elektrische Potential aufweist wie die erste metallische Ummantelung und als aktive Abschirmung dient. Die erfindungsgemäße Lösung bietet den Vorteil, dass die Reichweite der Sensoreinheit zur Detektion des sich an die Heckklappe annähernden Benutzers vergrößert wird. Dadurch wird bereits frühzeitig die Kommunikation zwischen einem Fahrzeugsteuergerät und einem Funkschlüssel des Benutzers gestartet, so dass bereits bei der Annäherung des Benutzers an die Heckklappe diese geöffnet wird.

Nach einer weiteren bevorzugten Ausführungsform der Erfindung ist vorgesehen, dass der Leiter des Koaxialkabels zumindest teilweise von einer ersten Isolierschicht des Koaxialkabels ummantelt ist.

Nach einer weiteren bevorzugten Ausführungsform der Erfindung ist vorgesehen, dass die erste Isolierschicht des Koaxialkabels ein εᵣ aufweist, welches einen Wert zwischen 5 und 1 aufweist. Der Vorteil ist, dass dadurch die Reichweite der Sensoreinheit vergrößert wird, weil das elektrische Feld einen größeren Detektionsbereich erzeugt.

Nach einer weiteren bevorzugten Ausführungsform der Erfindung ist vorgesehen, dass die erste Isolierschicht aus einem geschäumten Material besteht, welches Luftkammern aufweist.

Nach einer weiteren bevorzugten Ausführungsform der Erfindung ist vorgesehen, dass die erste Isolierschicht aus Luft besteht.

Nach einer weiteren bevorzugten Ausführungsform der Erfindung ist vorgesehen, dass die erste Isolierschicht zumindest teilweise von einer metallischen Schicht ummantelt ist, welche als Sensorelektrode dient.

Nach einer weiteren bevorzugten Ausführungsform der Erfindung ist vorgesehen, dass die metallische Schicht als Metallfolie und /oder Drahtgeflecht und/oder Draht, insbesondere als spiralförmig aufgewickelter Draht ausgebildet ist.

Nach einer weiteren bevorzugten Ausführungsform der Erfindung ist vorgesehen, dass die metallische Schicht zumindest teilweise von einer zweiten Isolierschicht, insbesondere aus Kunststoff ausgebildeten Isolierschicht, ummantelt ist, welche zur Isolierung gegen äußere Umwelteinflüsse dient, insbesondere um die metallischen Anteile des Koaxialkabel gegen Feuchtigkeit und Korrosion zu schützen.

Nach einer weiteren bevorzugten Ausführungsform der Erfindung ist vorgesehen, dass die Seele als Kupferdraht ausgebildet ist.

Nach einer weiteren bevorzugten Ausführungsform der Erfindung ist vorgesehen, dass die Sensoreinrichtung an einem Stoßfänger angeordnet ist.

Nach einer weiteren bevorzugten Ausführungsform der Erfindung ist vorgesehen, dass das als Sensoreinheit ausgebildete Koaxialkabel an mindestens einem Ende wasserdicht ausgebildet ist. Dadurch wird in vorteilhafterweise ausgeschlossen, dass Feuchtigkeit in die einzelnen Schichten der Sensoreinheit eindringt und das elektrische Feld, welches durch die Sensoreinheit erzeugt wird, gestört wird.

In den Figuren ist die Erfindung anhand eines Ausführungsbeispiel schematisch dargestellt. Es zeigen:
- Fig. 1: ein Fahrzeug mit einer in einem Stoßfänger angeordneten Sensoreinheit
- Fig. 2: die als Koaxialkabel ausgebildete Sensoreinheit aufweisend den Schichtaufbau in der Seitenansicht
- Fig. 3: einen Schnitt I-I durch das Koaxialkabel in Fig. 2

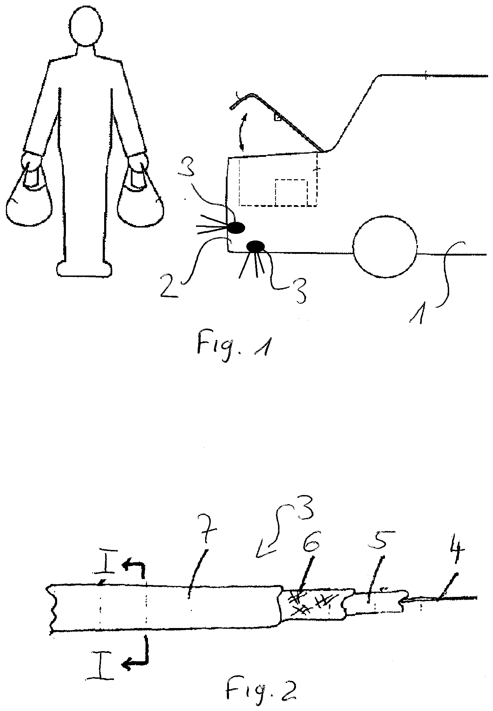

In der Figur 1 ist ein Fahrzeug 1 gezeigt, welches einen Stoßfänger 2 aufweist, in welchem zwei Sensoreinheiten 3 angeordnet sind, wobei die Eine zur Bodenebene ausgerichtet ist und die Andere im Wesentlichen 90° versetzt zur Bodenebene ausgerichtet ist.

Der Benutzer nähert sich einer Hecklappe des Fahrzeugs. Die Sensoreinheit 3 detektiert mit Hilfe des von der Sensoreinheit 3 erzeugten elektrischen Felds den Benutzer in einem angrenzenden Detektionsbereich, so dass über die Detektion die Betätigung der Heckklappe aktivierbar ist.

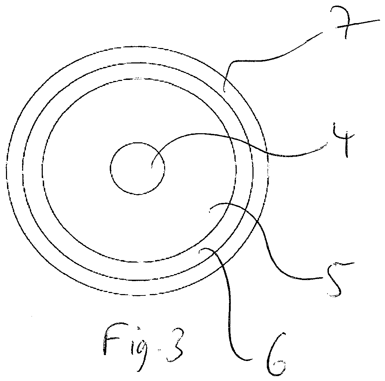

Wie in Figur 2 und 3 gezeigt ist die Sensoreinheit als Koaxialkabel ausgebildet, welches einen schichtweisen Aufbau aufweist. Die Sensoreinheit 3 ist als Koaxialkabel ausgebildet, wobei der als metallische Seele ausgebildete Leiter 4 des Koaxialkabels als aktive Abschirmung dient. Dabei weist die metallische Seele des Koaxialkabels das gleiche Potential wie die erste metallische Ummantelung auf. Die metallische Ummantelung bildet die Sensorelektrode. Dadurch wirkt die erste metallische Ummantelung als Sensorelektrode nicht nach innen, sondern verstärkt nach außen, d.h. es wird nach außen hin eine Feldverstärkung erreicht. Der Leiter 4 ist aus einem Kupferdraht ausgebildet. Der Leiter 4 des Koaxialkabels ist vollständig von einer ersten Isolierschicht 5 des Koaxialkabels ummantelt. Die erste Isolierschicht 5 des Koaxialkabels weist ein εᵣ, auf, welches einen Wert zwischen 5 und 1 aufweist. Die erste Isolierschicht 5 umfasst ein geschäumtes Material, welches Luftkammern aufweist. Die erste Schicht 5 umfasst vorzugsweise Polytetrafluorethylen, alternativ Polypropylen oder Polyethylen. Alternativ kann die erste Isolierschicht 5 auch lediglich aus Luft bestehen. Die erste Isolierschicht 5 ist wiederum vollständig von einer metallischen Schicht 6 ummantelt, welche als Sensorelektrode dient. Die Sensorelektrode baut ein elektrisches Feld auf. Wenn das elektrische Feld von einem Benutzer beeinflusst wird, indem der Benutzer in den Detektionsbereich der Sensoreinheit gelangt, wird das Fahrzugsteuergerät von der Sensoreinheit angesteuert und leitet den Vorgang zur Öffnung der Heckklappe ein. Die metallische Schicht 6 ist in diesem Ausführungsbeispiel als Metallfolie und Drahtgeflecht ausgebildet, wobei das Drahtgeflecht die Metallfolie überdeckt. Alternativ kann die metallische Schicht auch nur als spiralförmig aufgewickelter Draht ausgebildet sein, welcher die erste Schicht 5 ummantelt. Die metallische Schicht 6 ist vollständig von einer zweiten Isolierschicht 7 ummantelt, welche aus Kunststoff ausgebildeten ist und zur Isolierung gegen äußere Umwelteinflüsse dient, um die metallischen Anteile des Koaxialkabels gegen Feuchtigkeit und Korrosion zu schützen. Das als Sensoreinheit 3 ausgebildete Koaxialkabel ist an einem seiner Enden wasserdicht ausgebildet. Das andere Ende des Koaxialkabels dient zur Aufnahme einer Steckverbindung.

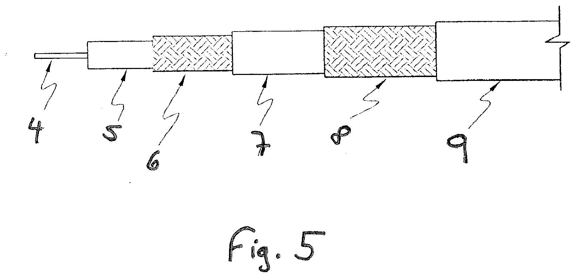

In Figur 5 ist als weiteres Ausführungsbeispiel ein Koaxialkabel dargestellt, das eine weitere metallische Ummantelung aufweist, wobei diese zusätzliche Ummantelung mit der Masse (Ground) verbunden ist, so dass diese Ummantelung als Abschirmung des Sensorsystem nach außen dient. Die Kabelseele weist dasselbe elektrische Potential wie die erste metallische Ummantelung auf und wirkt daher als aktive Abschirmung nach innen. Dadurch wird das elektrische Sensorfeld nach außen hin verstärkt.
Die zweite metallische Ummantelung soll dagegen den Sensor in den Bereichen unwirksam machen, wo keine Sensierung notwendig oder es zu Fehlsensierungen kommen kann.

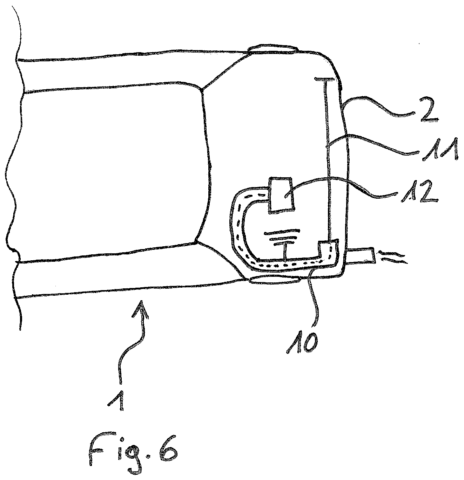

In Figur 6 ist das Gesamtsystem in einem Fahrzeug schematisch dargestellt. Von einem Steuergerät im Fahrzeug verläuft das Koaxialkabel, in diesem Fall mit zweiter metallischer Ummantelung, zum Heckbereich, wobei in der Sensorzone am Koaxialkabel die zweite metallische Ummantelung entfernt ist, so dass die Sensorelektrode (erste metallische Ummantelung) wirksam sein kann. Die Endbereiche des Koaxialkabels sind zum Schutz gegen Umwelteinflüsse isoliert. Die zweite metallische Ummantelung ist mit Masse (elektrisch, Batterie) verbunden und wirkt als Abschirmung für den Sensor.

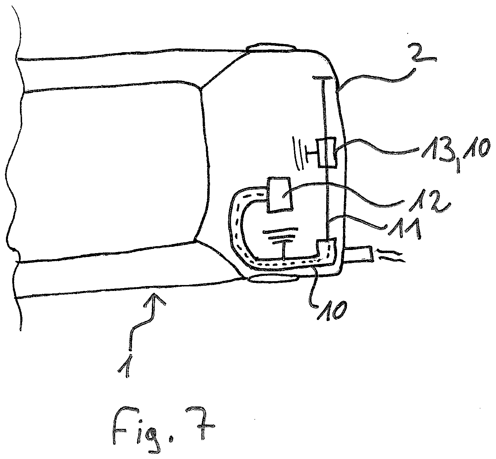

Figur 7 zeigt ein weiteres Ausführungsbeispiel, wobei mehrere Abschnitte des Koaxialkabel keine zweite metallische Ummantelung aufweisen. Dadurch wird das Kabel in mehrere sensierende Bereiche aufgeteilt. Der Zwischenabschnitt mit zweiter metallischer Ummantelung kann mit Masse verbunden oder ohne elektrische Verbindung sein.

Das Koaxialkabel kann mehrere Zwischenabschnitte mit und ohne zweiter metallischer Ummantelung aufweisen.

### Bezugszeichenliste

- 1: Fahrzeug
- 2: Stoßfänger
- 3: Sensoreinheit
- 4: Leiter, Seele (+ Potential), Aktive Abschirmung
- 5: erste Isolierschicht
- 6: erste metallische Schicht, Ummantelung, Sensorelektrode (+ Potential)
- 7: zweite Isolierschicht
- 8: zweite metallische Schicht, Ummantelung
- 9: dritte Isolierschicht
- 10: Koaxialkabelbereich mit zweiter metallischen Ummantelung
- 11: Koaxialkabelbereich ohne zweite metallische Ummantelung
- 12: Steuergerät
- 13: Zwischenabschnitt mit zweiter metallischen Ummantelung

## Patentansprüche

1. Vorrichtung zur Betätigung einer Tür oder Klappe eines Fahrzeugs, wobei die Vorrichtung eine Sensoreinheit aufweist, um eine Detektion eines Objektes in wenigstens einem an das Kraftfahrzeug angrenzenden Detektionsbereich zu ermöglichen, so dass über die Detektion die Betätigung des beweglichen Teils aktivierbar ist,
**dadurch gekennzeichnet, dass**
die Sensoreinheit als Koaxialkabel ausgebildet ist, dessen erste metallische Ummantelung die Sensorelektrode bildet, wobei ein als metallische Seele ausgebildeter Leiter des Koaxialkabels das gleiche elektrische Potential wie die erste metallische Ummantelung aufweist und als aktive Abschirmung dient.

2. Vorrichtung nach Anspruch 1, **dadurch gekennzeichnet, dass** der Leiter des Koaxialkabels zumindest teilweise von einer ersten Isolierschicht des Koaxialkabels ummantelt ist.

3. Vorrichtung nach Anspruch 2, **dadurch gekennzeichnet, dass** die erste Isolierschicht des Koaxialkabels ein εᵣ aufweist, welches einen Wert zwischen 5 und 1 aufweist.

4. Vorrichtung nach Anspruch 2 oder 3, **dadurch gekennzeichnet, dass** die erste Isolierschicht aus einem geschäumten Material besteht, welches Luftkammern aufweist.

5. Vorrichtung nach Anspruch 2 oder 3, **dadurch gekennzeichnet, dass** die erste Isolierschicht aus Luft besteht.

6. Vorrichtung nach einem der Ansprüche 1 bis 5, **dadurch gekennzeichnet, dass** die erste Isolierschicht zumindest teilweise von einer metallischen Schicht ummantelt ist, welche als Sensorelektrode dient.

7. Vorrichtung nach Anspruch 6 **dadurch gekennzeichnet, dass** die metallische Schicht als Metallfolie und /oder Drahtgeflecht und/oder Draht, insbesondere als spiralförmig aufgewickelter Draht ausgebildet ist.

8. Vorrichtung einem der Ansprüche 1 bis 7, **dadurch gekennzeichnet, dass** die metallische Schicht zumindest teilweise von einer zweiten Isolierschicht, insbesondere aus Kunststoff ausgebildeten Isolierschicht, ummantelt ist, welche zur Isolierung gegen äußere Umwelteinflüsse dient, insbesondere um die metallischen Anteile des Koaxialkabels gegen Feuchtigkeit und Korrosion zu schützen.

9. Vorrichtung nach einem der Ansprüche 1 bis 8, **dadurch gekennzeichnet, dass** die Seele als Kupferdraht ausgebildet ist.

10. Vorrichtung nach einem der Ansprüche 1 bis 9, **dadurch gekennzeichnet, dass** die Sensoreinrichtung an einem Stoßfänger angeordnet ist.

11. Vorrichtung nach einem der Ansprüche 1 bis 10, **dadurch gekennzeichnet, dass** das als Sensoreinheit ausgebildete Koaxialkabel an mindestens einem Ende wasserdicht ausgebildet ist.

12. Vorrichtung nach einem der vorherigen Ansprüche, **dadurch gekennzeichnet, dass** das Koaxialkabel von einer zusätzlichen zweiten metallischen Ummantelung umgeben ist.

13. Vorrichtung nach Anspruch 12 **dadurch gekennzeichnet, dass** die zweite metallische Ummantelung an Masse (Ground) angeschlossen ist.

14. Vorrichtung nach Anspruch 12 oder 13, **dadurch gekennzeichnet, dass** das Koaxialkabel von einer zusätzlichen äußeren Isolierschicht umgeben ist.

15. Vorrichtung nach einem der Ansprüche von 12 bis 14 **dadurch gekennzeichnet, dass** das Koaxialkabel bereichsweise, vorzugsweise im Endbereich, keine 2. metallische Ummantelung umfasst, so dass das Koaxialkabel in diesen Bereichen als Sensor wirkt.

16. Vorrichtung nach Anspruch 15 **dadurch gekennzeichnet, dass** das Koaxialkabel mehrere Abschnitte ohne zweite metallische Ummantelung aufweist.

17. Vorrichtung nach Anspruch 16, **dadurch gekennzeichnet, dass** die metallischen Ummantelungen der Zwischenabschnitte mit Masse (Ground) verbunden sind.

## Claims

1. Device for actuating a door or flap of a motor vehicle, wherein the device includes a sensor unit to enable detection of an object in at least one detection region adjacent to the motor vehicle, so that actuation of the moving part can be activated via the detection **characterised in that** the sensor unit is designed as a coaxial cable, of which the first metal sheath forms the sensor electrode, wherein a conductor of the coaxial cable in the form of a metal core has the same electric potential as the first metal sheath and serves as an active shield.

2. Device according to claim 1, **characterised in that** the conductor of the coaxial cable is at least partially covered by a first insulating layer of the coaxial cable.

3. Device according to claim 2, **characterised in that** the first insulating layer of the coaxial cable has a εᵣ which has a value between 5 and 1.

4. Device according to claim 2 or 3, **characterised in that** the first insulating layer is made from a foamed material which includes air chambers.

5. Device according to claim 2 or 3, **characterised in that** the first insulating layer consists of air.

6. Device according to any one of claims 1 to 5, **characterised in that** the first insulating layer is at least partially surrounded by a metallic layer which serves as a sensor electrode.

7. Device according to claim 6, **characterised in that** the metallic layer has the form of a metal foil and/or wire mesh and/or wire, particularly a spirally wound wire.

8. Device according to any one of claims 1 to 7, **characterised in that** the metallic layer is at least partially surrounded by a second insulating layer, particularly an insulating layer made of plastic, serves as insulation against external environmental influences, particularly to protect the metallic components of the coaxial cable from moisture and corrosion.

9. Device according to any one of claims 1 to 8, **characterised in that** the core is constructed as a copper wire.

10. Device according to any one of claims 1 to 9, **characterised in that** the sensor device is arranged on a bumper.

11. Device according to any one of claims 1 to 10, **characterised in that** at least one end of the coaxial cable which functions as the sensor unit is designed to be waterproof.

12. Device according to any one of the preceding claims, **characterised in that** the coaxial cable is surrounded by an additional, second metallic sheath.

13. Device according to claim 12, **characterised in that** the second metallic sheath is connected to earth (ground).

14. Device according to claim 12 or 13, **characterised in that** the coaxial cable is surrounded by an additional outer insulating layer.

15. Device according to any one of claims 12 to 14, **characterised in that** the second metallic sheath does not surround the coaxial cable in regions thereof, preferably in the end region, so that the coaxial cable functions as a sensor in these regions.

16. Device according to claim 15, **characterised in that** the coaxial cable has several sections without a second metallic sheath.

17. Device according to claim 16, **characterised in that** the metallic sheaths of the intermediate sections are connected to earth (ground).

## Revendications

1. Dispositif destiné à manoeuvrer une portière ou un hayon d'un véhicule, le dispositif comportant une unité de capteur pour permettre une détection d'un objet dans au moins une zone de détection adjacente au véhicule automobile, de sorte que par l'intermédiaire de la détection, la manoeuvre de la partie mobile soit activable,
**caractérisé en ce que**
l'unité de capteur est conçue en tant que câble coaxial dont la première gaine métallique forme l'électrode de capteur, un conducteur du câble coaxial, conçu en tant qu'âme métallique présentant le même potentiel électrique que la première gaine métallique et servant de blindage actif.

2. Dispositif selon la revendication 1, **caractérisé en ce que** le conducteur du câble coaxial est enveloppé au moins en partie d'une première couche isolante du câble coaxial.

3. Dispositif selon la revendication 2, **caractérisé en ce que** la première couche isolante du câble coaxial comporte un εᵣ qui présente une valeur comprise entre 5 et 1.

4. Dispositif selon la revendication 2 ou 3, **caractérisé en ce que** la première couche isolante est constituée d'une matière expansée, laquelle comporte des compartiments d'air.

5. Dispositif selon la revendication 2 ou 3, **caractérisé en ce que** la première couche isolante est constituée d'air.

6. Dispositif selon l'une quelconque des revendications 1 à 5, **caractérisé en ce que** la première couche isolante est enveloppée au moins en partie d'une couche métallique, qui sert d'électrode de capteur.

7. Dispositif selon la revendication 6, **caractérisé en ce que** la couche métallique est conçue en tant que film métallique et/ou que treillis métallique et/ou que fil métallique, notamment en tant que fil métallique enroulé en spirale.

8. Dispositif selon l'une quelconque des revendications 1 à 7, **caractérisé en ce que** la couche métallique est enveloppée au moins en partie d'une deuxième couche isolante, notamment d'une couche isolante conçue en matière plastique, laquelle sert d'isolation contre des influences environnementales extérieures, notamment pour protéger les parts métalliques du câble coaxial contre l'humidité et la corrosion.

9. Dispositif selon l'une quelconque des revendications 1 à 8, **caractérisé en ce que** l'âme est conçue en tant que fil de cuivre.

10. Dispositif selon l'une quelconque des revendications 1 à 9, **caractérisé en ce que** le dispositif de capteur est placé sur un pare-chocs.

11. Dispositif selon l'une quelconque des revendications 1 à 10, **caractérisé en ce que** le câble coaxial conçu en tant qu'unité de capteur est conçu en étant étanche à l'eau sur au moins une extrémité.

12. Dispositif selon l'une quelconques des revendications précédentes, **caractérisé en ce que** le câble coaxial est entouré d'une deuxième gaine métallique supplémentaire.

13. Dispositif selon la revendication 12, **caractérisé en ce que** la deuxième gaine métallique est reliée la masse (Ground).

14. Dispositif selon la revendication 12 ou 13, **caractérisé en ce que** le câble coaxial est entouré d'une deuxième couche isolante extérieure.

15. Dispositif selon l'une quelconque des revendications 12 à 14, **caractérisé en ce que** par zones, de préférence dans la zone d'extrémité, le câble coaxial ne comprend aucune 2^{ème} gaine métallique, de sorte que dans ces zones, le câble coaxial agit comme un capteur.

16. Dispositif selon la revendication 15, **caractérisé en ce que** le câble coaxial comporte plusieurs segments sans deuxième gaine métallique.

17. Dispositif selon la revendication 16, **caractérisé en ce que** les gaines métalliques des tronçons intermédiaires sont reliées à la masse (Ground).
